# EUROPÄISCHE PATENTSCHRIFT

(11) **EP 3 833 632 B1**
(45) Veröffentlichungstag und Bekanntmachung des Hinweises auf die Patenterteilung: **11.09.2024**
(21) Anmeldenummer: 19755519.6
(22) Anmeldetag: 31.07.2019
(51) Int. Cl.: B81C 1/00

(54) **VERFAHREN ZUR HERSTELLUNG VON MIKROSTRUKTUREN**
METHOD FOR PRODUCING MICROSTRUCTURES
PROCÉDÉ DE RÉALISATION DE MICROSTRUCTURES

(30) Priorität: 09.08.2018 DE 102018119405; 20.03.2019 DE 102019107114
(43) Veröffentlichungstag der Anmeldung: 16.06.2021
(73) Patentinhaber: LPKF Laser & Electronics SE, 30827 Garbsen (DE)
(72) Erfinder: OSTHOLT, Roman, 30855 Langenhagen (DE); AMBROSIUS, Norbert, 30827 Garbsen (DE)
(74) Vertreter: Scheffler, Jörg
(86) Internationale Anmeldenummer: PCT/DE2019/100701
(87) Internationale Veröffentlichungsnummer: WO 2020/030222

(56) Entgegenhaltungen:
- DE-A1- 102011 085 353
- US-A1- 2016 088 414

## Beschreibung

Die Erfindung betrifft ein Verfahren zur Herstellung von Mikrostrukturen insbesondere MEMS und MOEMS (microelectromechanical systems und microoptoelectromechanical systems) in einem Glassubstrat mit membranartigen, überbrückenden oder überhängenden Flächen infolge einer durch ein Ätzverfahren bewirkten Materialschwächung durch einen Materialabtrag zur Erzeugung einer Ausnehmung (Kavität) in dem Glassubstrat und durch Einbringen von Modifikationen mittels Laserstrahlung entlang zumindest einer vorzugsweise ringförmig geschlossenen Umfangskontur in das Glassubstrat und Ätzen des Glassubstrats von einer der Membranschicht abgewandten Seite des Glassubstrats, wodurch der Materialabtrag zumindest im Wesentlichen entlang der Umfangskontur der Modifikationen der lasermodifizierten Bereiche erfolgt.

Derartige Mikrostrukturen sind beispielsweise als Druckerfassungsvorrichtungen oder Mikrofone auf der Basis solcher mikroelektromechanischen Systeme (MEMS) bereits bekannt, wobei eine überbrückende Struktur geschaffen wird, die als Membran die Basis für das mikromechanische System bildet. Wesentlicher Aspekt ist daher eine gezielte Materialschwächung, durch die biegsame Flächen geschaffen werden.

Die überhängenden oder überbrückenden Strukturen eignen sich daher optimal für Mikrophone oder Sensoren. Das in der Praxis derzeit nahezu ausschließlich eingesetzte Verfahren zur Herstellung solcher Strukturen ist das reaktive lonentiefenätzen (deep reactive ion etching, DRIE), welches einen kontrollierten Abtrag zur Reduzierung der Schichtstärke bis auf die gewünschte Reststärke ermöglicht. Dieses Verfahren ist derzeit nur in Verbindung mit Silizium einsetzbar, was zu hohen Materialkosten führt.

Beispielsweise offenbart die US 4,236,137 A einen Halbleiterdruckmessumformer. Ferner offenbaren die US 5,178,016 A und die US 6,093,579 A ebenfalls Halbleiterdrucksensoren.

Dokument DE 10 2011 085353 A1 offenbart ein Herstellungsverfahren für eine Halbleitervorrichtung, wobei das Verfahren das Ausbilden einer Reformschicht durch Bestrahlen des Substrats mit einem gepulsten Laserstrahl enthält, und anschließend das Entfernen der Reformschicht durch Ätzen erfolgt.

Die US 2016 / 0 088 414 A1 beschreibt ein Verfahren zur Herstellung eines Mikrofons mit einem mikroelektromechanischen System (MEMS). Dabei wird eine Öffnung durch Laserschneiden auf der Rückseite eines Halbleitersubstrats gebildet und anschließend die Rückseite des Halbleitersubstrats unter Verwendung eines reaktiven lonentiefenätzens geätzt, um einen Hohlraum zu bilden, der eine Membran freilegt.

Die DE 10 2017 216 418 A1 betrifft eine Druckerfassungsvorrichtung mit verlängerter, flacher polygonförmiger Kavität, insbesondere eine auf einem mikromechanischen System (MEMS) basierende Druckerfassungsvorrichtung. Diese hat ein Silizium-Trägersubstrat, eine in einer Oberseite des Silizium-Trägersubstrats gebildete verlängerte, flache, polygonförmige Kavität, eine eingebettete Silizium-Dioxid-Schicht, eine auf der Silizium-Dioxid-Schicht gebildete Vorrichtungsschicht und zumindest vier Bondpads aufweist, die in einer Oberseite der Vorrichtungsschicht geformt und darauf angeordnet sind. Die zumindest vier Bondpads sind von der verlängerten, flachen, polygonförmigen Kavität beabstandet. Genauer gesagt sind die zumindest vier Bondpads von der verlängerten, flachen, polygonförmigen Kavität derart beabstandet, dass diese nicht mit der verlängerten, flachen, polygonförmigen Kavität in Verbindung stehen. Die Druckerfassungsvorrichtung kann eine über der polygonförmigen Kavität angeordnete Membran aufweisen, deren Form durch die Form der polygonförmigen Kavität definiert ist und deren Größe im Wesentlichen gleich der Größe der polygonförmigen Kavität ist.

Es ist bekannt, dass bei MEMS-Druckerfassungsvorrichtungen Druck-Nichtlinearitäten (pressure nonlinearity) infolge einer Durchbiegung einer Silizium-Membran auftreten können. Die Fähigkeit einer Membran, sich durchzubiegen, bestimmt allerdings auch die Fähigkeit der MEMS-Druckerfassungsvorrichtung zum Erfassen von Druckänderungen. Nimmt die Membrandurchbiegung zu, nimmt auch die Ausgangsnichtlinearität zu.

Die Druckempfindlichkeit einer MEMS-Druckerfassungsvorrichtung wird problematischer, wenn sich die Membrangröße verringert. Kleinere Membranen und kleinere MEMS-Druckerfassungsvorrichtungen ermöglichen allerdings eine Reduzierung der Herstellungskosten sowohl für die MEMS -Druckerfassungsvorrichtung selbst als auch für das Gehäuse, in dem die MEMS -Druckerfassungsvorrichtung platziert werden soll.

Es sind auch bereits aus derartigen Mikrostrukturen aufgebaute Mikrofone bekannt, die ähnlich einem Drucksensor aufgebaut sind und die den Schalldruck in ein elektrisches Signal wandeln, während ein Leckpfad für einen statischen Druckausgleich zwischen Volumina vor und hinter den Mikrofonen sorgt. Sie bestehen aus wenigstens einer freistehenden Struktur, die zur Umgebung exponiert ist und die sich entsprechend einem einwirkenden Schalldruck bewegt.

Dabei wird eine Bewegung einer Membran durch eine Messung einer Kapazität zwischen der Membran und einer perforierten Gegenelektrode, die vor oder hinter der Membran positioniert ist, erfasst.

Ein alternatives bekanntes Grundprinzip, welches die Detektion der Bewegung der freistehenden Struktur erlaubt, basiert auf dem direkten piezoelektrischen Effekt. In einem derartigen Mikrofon wird durch das Durchbiegen einer Struktur eine piezoelektrische Schicht beeinflusst, woraufhin auf ihrer Oberfläche eine elektrische Ladung entsteht. Diese Ladung kann als eine elektrische Ausgangsspannung erfasst und ausgewertet werden

Das gattungsgemäße Verfahren zur Präzisionsbearbeitung von Glas mittels laserinduziertem Tiefenätzen ist unter der Bezeichnung LIDE (Laser Induced Deep Etching) bekannt geworden. Dabei ermöglicht das LIDE-Verfahren das Einbringen von extrem präzisen Löchern und Strukturen in höchster Geschwindigkeit und schafft somit die Voraussetzungen für den vermehrten Einsatz von Glas als Werkstoff in der Mikrosystemtechnik.

Die DE 10 2011 085 353 A1 offenbart ein Verfahren zur Herstellung von Mikrostrukturen in einem Substrat mit überbrückenden oder überhängenden Flächen infolge einer durch ein Ätzverfahren bewirkten Materialschwächung durch einen Materialabtrag zur Erzeugung einer Ausnehmung in dem Substrat, wobei in einem ersten Schritt Modifikationen mittels Laserstrahlung entlang einer geschlossenen Umfangskontur in das Glassubstrat eingebracht werden und nachfolgend eine der Membranschicht abgewandte Seite des Glassubstrats einem Ätzangriff ausgesetzt wird, durch den der Materialabtrag in den lasermodifizierten Bereichen erfolgt.

Die Aufgabe der vorliegenden Erfindung besteht darin, eine Mikrostruktur zu schaffen, mit der eine Verkleinerung der Matrizengröße einer MEMS-Druckerfassungsvorrichtung bei Vergrößerung der Empfindlichkeit und Verringerung der Druck-Nichtlinearitäten erzielt werden kann.

Diese Aufgabe wird mit einer der Mikrostrukturen gemäß dem unabhängigen Anspruch 1 gelöst. Bevorzugte Ausgestaltungen sind in den Unteransprüchen angegeben.

Erfindungsgemäß werden die Mikrostrukturen in dem Glassubstrat erzeugt durch Aufbringen einer Opferschicht auf das Glassubstrat in einem ersten Bereich, welcher die Umfangskontur der Modifikationen einschließt, Aufbringen einer Membranschicht auf die Opferschicht in einem den ersten Bereich einschließenden zweiten Bereich, Ätzen des Glassubstrats von einer der Membranschicht abgewandten Seite des Glassubstrats bis die Opferschicht erreicht wird, sodass es zu einer Auflösung oder Reduzierung der Opferschicht und schließlich zu einem Trennen der Verbindung der von der Umfangskontur eingeschlossenen Kontur des Glassubstrats von dem umgebenden Glassubstrat sowie von der Membranschicht kommt.

Insbesondere werden in einem ersten Schritt Modifikationen mittels Laserstrahlung entlang einer vorzugsweise ringförmig, nicht zwingend kreisförmig geschlossenen Umfangskontur in das Glassubstrat eingebracht und zumindest eine Membranschicht zur Herstellung der überbrückenden oder überhängenden Flächen auf das Glassubstrat flächig aufgebracht, wobei zumindest in den die Umfangskontur der Modifikationen einschließenden Teilflächen, eine Opferschicht zwischen dem Glassubstrat und der Membranschicht eingeschlossen wird, wobei nachfolgend eine der Membranschicht abgewandte Seite des Glassubstrats einem Ätzangriff ausgesetzt wird, durch den der Materialabtrag vor allem entlang der Umfangskontur der lasermodifizierten Bereiche erfolgt, bis die Opferschicht erreicht wird, sodass es zu einer Auflösung oder Reduzierung der Opferschicht durch Querätzen und schließlich zu einem Trennen der Verbindung der von der Umfangskontur eingeschlossenen Kontur des Glassubstrats von dem umgebenden Glassubstrat sowie der Membranschicht kommt.

Der Erfindung liegt die überraschende Erkenntnis zugrunde, dass durch die Verwendung eines Glassubstrats anstelle der bisher nahezu ausschließlich eingesetzten Silizium-Substrate die sogenannten Druck-Nichtlinearitäten deutlich vermindert werden konnten, was einerseits aus den diesbezüglich besseren Materialeigenschaften des Glassubstrats, andererseits aus der wesentlich geringeren Toleranz in der Schichtdicke der Membranschicht resultiert. Insbesondere wird erfindungsgemäß lediglich das Glassubstrat einschließlich der Opferschicht abgetragen, während die Membranschicht unverändert erhalten bleibt, sodass diese über die gesamte Auftragsfläche homogen ist. Mit anderen Worten endet der Materialabtrag bei dem Ätzabtrag zuverlässig bei Erreichen der Opferschicht, sodass Fehlereinflüsse bei der Durchführung des Verfahrens auf ein Minimum reduziert sind. Zugleich lassen sich durch das erfindungsgemäße Verfahren die Herstellungskosten aufgrund der Verwendung von Glas anstelle von Silizium wesentlich reduzieren, wobei zudem die erheblich größere Fläche verfügbarer Glassubstrate im Verhältnis zu den diesbezüglich limitierten Siliziumsubstraten zu einem weiteren Kostenvorteil führen.

Dabei hat sich gezeigt, dass die Opferschicht nicht vollständig aufgelöst werden muss, sondern bereits nach einem kurzzeitigen Ätzangriff die Verbindung zu dem Glassubstrat und/oder der Membranschicht derart geschwächt ist, dass sich die Verbindung löst und der von der Umfangskontur eingeschlossene Glaskörper ablöst.

Erfindungsgemäß kann durch den ersten Ätzschritt eine konturierte Außenfläche des Glassubstrats beispielsweise in Form von ringförmigen Vertiefungen infolge des Ätzangriffs eingebracht werden, die dann formgebend für die im nachfolgenden Prozessverlauf aufzubringende Membranschicht wirkt. Die Membranschicht ist somit nicht auf einen ebenen Verlauf beschränkt, sondern kann beispielsweise eine gewellte Form aufweisen, die vergleichbar mit einem Faltenbalg als Zugkraftentlastungsstruktur dienen kann. In ähnlicher Weise können so auch Membranen für Lautsprecher oder Drucksensoren hergestellt werden. Erfindungsgemäß kann so nahezu jede beliebige Topographie erzeugt werden.

Dabei hat es sich bereits als besonders zweckmäßig erwiesen, wenn die Modifikationen entlang mehrerer ringförmig geschlossener Umfangskonturen in das Glassubstrat eingebracht werden, wobei die Umfangskonturen einander vorzugsweise konzentrisch einschließen.

Selbstverständlich können neben kreisförmigen Umfangskonturen sowie beliebig geformten Konturen auch polygonale Umfangskonturen erzeugt werden, wobei benachbarte Umfangskonturen insbesondere zueinander parallel beabstandet sind, sodass der Abstand zu den benachbarten Umfangskonturen im Verlauf der Umfangskontur konstant ist.

Die Intensität der Laserstrahlung kann für verschiedene Umfangskonturen übereinstimmend gewählt werden. Besonders sinnvoll ist es jedoch für viele Anwendungen, wenn die Parameter der Laserstrahlung entlang einer ersten Umfangskontur von den Parametern der Laserstrahlung entlang einer von der ersten Umfangskontur eingeschlossenen zweiten Umfangskontur abweichen, sodass beispielsweise die Amplitude der Vertiefungen zur Mitte des ersten Bereichs abnimmt.

Außerdem kann auch der Ätzangriff inhomogen gestaltet werden, wenn beispielsweise durch die Verwendung einer Maskierung lediglich Teilbereiche des Glassubstrats dem Ätzangriff ausgesetzt werden.

Der Schichtauftrag kann mit verschiedenen, an sich bekannten Verfahren auf der Außenfläche des Glassubstrats erfolgen, wobei sich ein Sputterverfahren für den Aufbau der Membranschicht oder der Opferschicht bereits als zweckmäßig erwiesen hat.

Die Umfangskontur kann entlang einer zylindrischen oder polygonalen Umfangsfläche eingebracht werden, wobei auch solche, mit Kanten ausgestattete Konturen erzeugt werden können, die mit den bisherigen Verfahren nicht realisierbar waren. Gemäß einer weiteren besonders praxisrelevanten Ausgestaltung kann die Umfangskontur in einer der Membranschicht zugewandten Seite von einer der Membranschicht abgewandten Seite abweichend ausgeführt sein, um so beispielsweise einen kegel- bzw. kegelstumpfförmigen Verlauf der Umfangskontur und der so erzeugten Ausnehmung zu erreichen. Insbesondere kann so ein definierter Öffnungswinkel erzeugt werden, welcher für viele technische Anwendungen zu einem erheblichen Vorteil führt.

Obwohl es sich in der praktischen Erprobung bereits als vorteilhaft erwiesen hat, wenn die Modifikationen vor dem Aufbringen der Opferschicht und der Membranschicht in das Glassubstrat eingebracht werden, können diese gemäß einem abgewandelten Verfahren auch noch nachträglich, also bei bereits mit Opferschicht und Membranschicht vorkonfektionierten Glassubstraten eingebracht werden.

Dabei kann die Opferschicht beschränkt auf die Bereiche der Umfangskontur insbesondere mit einer in der Praxis durch Erprobung zu bestimmenden Überlappung selektiv auf das Glassubstrat aufgebracht werden. Selbstverständlich ist demgegenüber ein vollflächiger Auftrag der Opferschicht ebenfalls realisierbar, wobei ein nachfolgender Abtrag der Zwischenbereiche sinnvoll ist, um eine vollständige Trennung des Glassubstrats von der Membranschicht zu vermeiden.

Dabei hat es sich bereits als vorteilhaft erwiesen, wenn zum vereinfachten Herauslösen der von der Umfangskontur eingeschlossene Glaskörper zumindest eine weitere Modifikation innerhalb der Umfangskontur eingebracht hat, und durch den nachfolgenden Ätzangriff eine kanalartige Ausnehmung zwischen einer der Membranschicht abgewandten Außenfläche und der Opferschicht erzeugt wird. Dadurch wird das Herauslösen begünstigt, indem durch den so geschaffenen Fluiddurchlass ein hydraulischer Druckausgleich ermöglicht wird. Die Anzahl und Beschaffenheit solcher Ausgleichskanäle kann an den jeweiligen Anwendungszweck entsprechend angepasst werden.

Gemäß einer weiteren, ebenfalls besonders praxisgerechten Abwandlung des Verfahrens wird während des Ätzangriffs das Glassubstrat insbesondere mittels Ultraschall in hochfrequente Schwingung versetzt, um so das Herauslösen des von der Umfangskontur eingeschlossenen Bereichs des Glassubstrats zu erleichtern oder zu beschleunigen.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in
- Fig. 1: einzelne Verfahrensschritte zur Herstellung überhängender Strukturen entlang einer ringförmig geschlossenen Umfangskontur;
- Fig. 2: die in der Figur 1 gezeigten Verfahrensschritte zur Herstellung mehrerer, einander einschließender ringförmig geschlossener Umfangskonturen;
- Fig. 3: eine Variante des in der Figur 2 gezeigten Verfahrens mit mehreren lediglich einseitig eingebrachten Umfangskonturen.

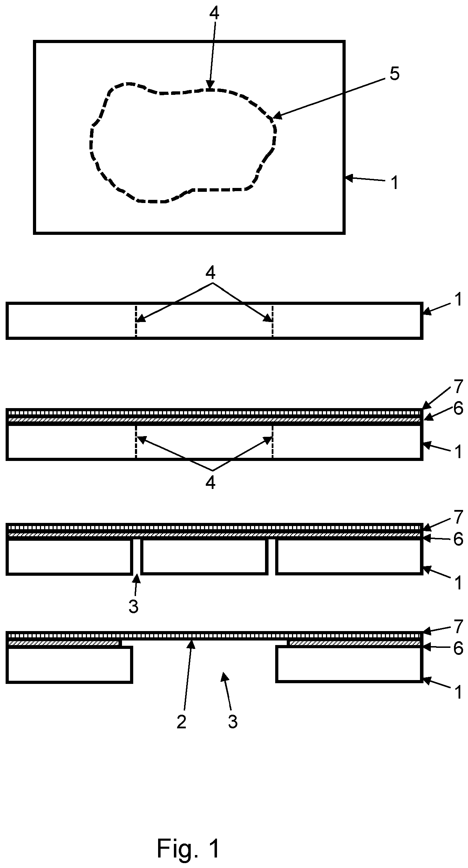

Das erfindungsgemäße Verfahren zur Herstellung von Mikrostrukturen in einem Substrat 1 mit membranartigen, überbrückenden oder überhängenden Flächen 2 wird nachstehend anhand der in der Figur 1 dargestellten einzelnen Verfahrensschritte näher erläutert. Die überhängenden Flächen 2 entstehen dabei infolge einer durch ein Ätzverfahren bewirkten Materialschwächung und durch einen Materialabtrag zur Erzeugung einer Ausnehmung 3 in dem Substrat. Hierzu werden in einem ersten Verfahrensschritt in das beispielsweise aus Glas bestehende Substrat 1 mittels Laserstrahlung Modifikationen 4 entlang einer ringförmig geschlossenen Umfangskontur 5 in das Substrat 1 eingebracht, wie dies in einer Draufsicht auf das Substrat 1 zu erkennen ist. Auf das so modifizierte Substrat 1 werden in einem ersten Schritt eine gegenüber einem nasschemischen Ätzbad nicht resistente Opferschicht 6 und darauf eine gegenüber dem Ätzmedium resistente Membranschicht 7, beispielsweise eine Metallschicht, aufgebracht.

Anschließend erfolgt vornehmlich auf einer der Membranschicht 7 abgewandten Seite des Substrats 1 ein Ätzangriff durch ein nicht weiter gezeigtes Ätzmedium. Dabei führt der Ätzangriff zu einem linienförmigen, nutenförmigen Abtrag des Substratmaterials entlang der Umfangskontur 5, wobei der Ätzfortschritt zumindest im Wesentlichen senkrecht zu der Oberfläche des Substrats 1 erfolgt. Bei fortschreitendem Abtrag und entsprechend vertieftem nutenförmigen Materialabtrag wird schließlich die Opferschicht 6 erreicht. Diese löst sich infolge der Ätzwirkung nicht nur entsprechend der Umfangskontur 5, sondern auch in Querrichtung hierzu auf. Dadurch verliert der von der Umfangskontur 5 eingeschlossene Bereich seine Haftung bzw. Bindung und lässt sich mühelos unter der Einwirkung der Schwerkraft nach unten aus dem Substrat 1 herauslösen. Die gewünschte, beispielsweise als Membran nutzbare Überhangkontur 5 überspannt somit die Ausnehmung 3.

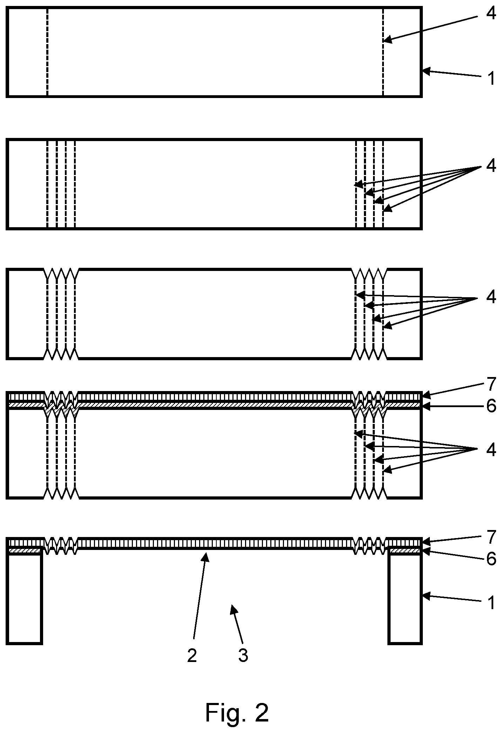

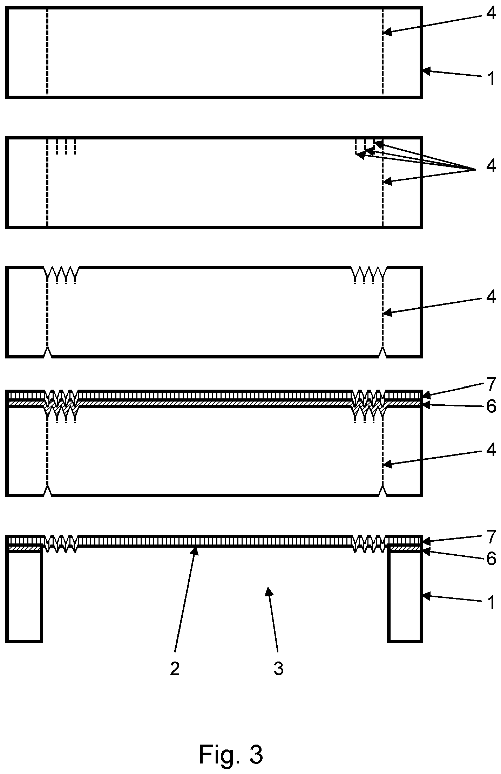

In den Figuren 2 und 3 sind darüber hinaus noch Varianten des Verfahrens dargestellt, die sich durch mehrere einander beispielsweise konzentrisch einschließende Umfangskonturen 5 in Verbindung mit einem zusätzlichen Ätzschritt vor dem Aufbringen der Opferschicht 6 sowie der Membranschicht 7 von dem in der Figur 1 gezeigten Verfahren unterscheiden.

Die verschiedenen Umfangskonturen 5 müssen hierzu nicht in einem einheitlichen Abstand zueinander angeordnet sein. Beispielsweise könnten sich benachbarte Umfangskonturen 5 auch schneiden. Ebenso wenig müssen die eingeschlossenen Umfangskonturen 5 ringförmig geschlossen sein, sondern können ebenso auf einen Flächenabschnitt des Substrats 1 beschränkt in dieses eingebracht wird. Nach Abschluss der Lasermodifikation entlang der verschiedenen Umfangskonturen 5 erfolgt zunächst ein erster Ätzangriff in einem Ätzbad, wodurch im Bereich der Umfangskonturen 5 ein Materialabtrag als nutenförmige Ausnehmung 3 in Abhängigkeit der Modifikation mit übereinstimmender oder unterschiedlicher Tiefe in die Substratoberfläche eingebracht werden. In der im nächsten Schritt entsprechend dem in der Figur 1 gezeigten Verfahrensschritt darauf aufgebrachten Opferschicht 6 sowie Membranschicht 7 bildet sich die unebene Kontur entsprechend ab. Das nachfolgende Ätzen einer der Membranschicht 7 abgewandten Seite des Substrats 1 führt zu einem linienförmigen Abtrag des Substratmaterials entlang aller Umfangskonturen 5, sodass schließlich der von der äußeren Umfangskontur 5 eingeschlossene Bereich aus dem Substrat 1 herausgelöst wird. Die Fläche 2 weist somit neben ebenen Bereichen auch randseitig konturierte, wellenförmige Bereiche auf, die beispielsweise im Sinne eines Faltenbalgs als Längenausgleich dienen können. Insbesondere erhält die Überhangkontur hierdurch abschnittsweise flexible oder elastische Eigenschaften, die vollkommen neue Einsatzmöglichkeiten eröffnen.

Bei dem in der Figur 3 gezeigten Verfahren entspricht das Ergebnis dem in der Figur 2 gezeigten Verfahren. Die zur Konturbildung der Membranschicht 7 dienenden eingeschlossenen Umfangskonturen 5 erstrecken sich bei dieser Variante nicht über die gesamte Materialstärke des Substrats 1, sondern beschränken sich im Wesentlichen auf einen oberflächennahen Bereich der aufzubringenden, entsprechend konturierten Membranschicht 7. Diese eine geringere Eindringtiefe aufweisenden Modifikationen 4 werden beispielsweise durch veränderte Laserparameter erzeugt. Das Herauslösen des von der äußeren Umfangskontur 5 eingeschlossenen Bereichs des Substrats 1 kann dabei, wie bei der in der Figur 1 gezeigten Variante, in einem einzigen Stück erfolgen.

### BEZUGSZEICHENLISTE

- 1: Substrat
- 2: Fläche
- 3: Ausnehmung
- 4: Modifikation
- 5: Umfangskontur

- 6: Opferschicht
- 7: Membranschicht

## Patentansprüche

1. Verfahren zur Herstellung von Mikrostrukturen in einem Glassubstrat, insbesondere aus Quarzglas, mit membranartigen, überbrückenden oder überhängenden Flächen (2) infolge einer durch ein Ätzverfahren bewirkten Materialschwächung durch einen Materialabtrag zur Erzeugung zumindest einer Ausnehmung (3) in dem Glassubstrat, mit den Verfahrensschritten:
• Einbringen von Modifikationen (4) mittels Laserstrahlung entlang zumindest einer vorzugsweise ringförmig geschlossenen Umfangskontur (5) in das Glassubstrat und
• Ätzen des Glassubstrats von einer der Membranschicht (7) abgewandten Seite des Glassubstrats, wodurch der Materialabtrag zumindest im Wesentlichen entlang der Umfangskontur (5) der Modifikationen (4) der lasermodifizierten Bereiche erfolgt,
• **gekennzeichnet durch** das
• Aufbringen einer Opferschicht (6) auf das Glassubstrat in einem ersten Bereich, welcher die Umfangskontur (5) der Modifikationen (4) einschließt,
• Aufbringen einer Membranschicht (7) auf die Opferschicht (6) in einem den ersten Bereich einschließenden zweiten Bereich,
• Ätzen des Glassubstrats von einer der Membranschicht (7) abgewandten Seite des Glassubstrats bis die Opferschicht (6) erreicht wird, sodass es zu einer Auflösung oder Reduzierung der Opferschicht (6) und schließlich zu einem Trennen der Verbindung der von der Umfangskontur (5) eingeschlossenen Kontur des Glassubstrats von dem umgebenden Glassubstrat sowie von der Membranschicht (7) kommt.

2. Verfahren nach zumindest einem der vorhergehenden Ansprüche, **dadurch gekennzeichnet, dass** nach dem Einbringen der Modifikationen (4) mittels Laserstrahlung in das Glassubstrat zunächst zumindest eine Außenfläche des Glassubstrats einem Ätzangriff ausgesetzt und dadurch zumindest eine Ausnehmung (3) eingebracht wird, und dass anschließend nacheinander die Opferschicht (6) in dem ersten Bereich und die Membranschicht (7) in dem zweiten Bereich zumindest auf die mit der Ausnehmung (3) versehene Außenfläche aufgebracht werden und anschließend die der Membranschicht abgewandte Außenfläche des Glassubstrats einem erneuten Ätzangriff ausgesetzt wird, bis die Verbindung der von der Umfangskontur (5) eingeschlossenen Kontur des Glassubstrats von dem umgebenden Glassubstrat sowie von der Membranschicht (7) getrennt wird.

3. Verfahren nach zumindest einem der vorhergehenden Ansprüche, **dadurch gekennzeichnet, dass** die Modifikationen (4) entlang mehrerer ringförmig geschlossener Umfangskonturen (5) in das Glassubstrat eingebracht werden, wobei die Umfangskonturen (5) einander einschließen.

4. Verfahren nach zumindest einem der vorhergehenden Ansprüche, **dadurch gekennzeichnet, dass** benachbarte Umfangskonturen (5) zueinander parallel beabstandet in das Glassubstrat eingebracht werden.

5. Verfahren nach zumindest einem der vorhergehenden Ansprüche, **dadurch gekennzeichnet, dass** die Parameter der Laserstrahlung entlang einer ersten Umfangskontur (5) von den Parametern der Laserstrahlung entlang einer von der ersten Umfangskontur (5) eingeschlossenen zweiten Umfangskontur (5) abweichen.

6. Verfahren nach zumindest einem der vorhergehenden Ansprüche, **dadurch gekennzeichnet, dass** zumindest einer der Ätzangriffe insbesondere durch Verwendung einer Maskierung auf Teilbereiche der Umfangskontur (5) begrenzt ist.

7. Verfahren nach zumindest einem der vorhergehenden Ansprüche, **dadurch gekennzeichnet, dass** die Membranschicht (7) und/oder die Opferschicht (6) mittels eines Sputterverfahrens aufgebracht werden.

8. Verfahren nach zumindest einem der vorhergehenden Ansprüche, **dadurch gekennzeichnet, dass** die Umfangskontur (5) entlang einer zylindrischen oder polygonalen Umfangsfläche eingebracht wird.

9. Verfahren nach zumindest einem der vorhergehenden Ansprüche, **dadurch gekennzeichnet, dass** die Umfangskontur in einem der Membranschicht (7) zugewandten Seite abweichend von einer Umfangskontur (5) an einer der Membranschicht (7) abgewandten Seite eingebracht wird.

10. Verfahren nach zumindest einem der vorhergehenden Ansprüche, **dadurch gekennzeichnet, dass** die Modifikationen (4) vor dem Aufbringen der Opferschicht (6) und der Membranschicht (7) in das Glassubstrat eingebracht werden.

11. Verfahren nach zumindest einem der vorhergehenden Ansprüche, **dadurch gekennzeichnet, dass** zunächst ein vollflächiger Auftrag der Opferschicht (6) und nachfolgend ein Abtrag der Opferschicht (6) in den Zwischenbereichen zwischen den Umfangskonturen (5) durchgeführt wird.

12. Verfahren nach zumindest einem der vorhergehenden Ansprüche, **dadurch gekennzeichnet, dass** zumindest eine weitere Modifikation (4) innerhalb der Umfangskontur (5) in das Glassubstrat eingebracht wird.

13. Verfahren nach zumindest einem der vorhergehenden Ansprüche, **dadurch gekennzeichnet, dass** während des Ätzangriffs das Glassubstrat insbesondere mittels Ultraschall in hochfrequente Schwingung versetzt wird.

## Claims

1. Process for producing microstructures in a glass substrate, in particular made of quartz glass, with membrane-like, bridging or overhanging surfaces (2) as a result of a weakening of material brought about by an etching process by removal of material to create at least one recess (3) in the glass substrate, comprising the following process steps:
• introducing modifications (4) into the glass substrate by means of laser radiation along at least one preferably annularly closed peripheral contour (5) and
• etching the glass substrate from a glass substrate side facing away from the membrane layer (7), as a result of which material is removed at least substantially along the peripheral contour (5) of the modifications (4) of the laser-modified regions,
• **characterized by**
• applying a sacrificial layer (6) to the glass substrate in a first region which encloses the peripheral contour (5) of the modifications (4),
• applying a membrane layer (7) to the sacrificial layer (6) in a second region enclosing the first region,
• etching the glass substrate from a glass substrate side facing away from the membrane layer (7) until the sacrificial layer (6) is reached, with the result that dissolution or reduction of the sacrificial layer (6) and lastly separation of the connection of the glass substrate contour enclosed by the peripheral contour (5) from the surrounding glass substrate and from the membrane layer (7) occurs.

2. Process according to at least one of the preceding claims, **characterized in that,** after the modifications (4) have been introduced into the glass substrate by means of laser radiation, firstly at least one outer surface of the glass substrate undergoes an etching attack and as a result at least one recess (3) is introduced, and **in that** then successively the sacrificial layer (6) in the first region and the membrane layer (7) in the second region are applied at least to the outer surface provided with the recess (3), and then the glass substrate outer surface facing away from the membrane layer undergoes another etching attack, until the connection of the glass substrate contour enclosed by the peripheral contour (5) is separated from the surrounding glass substrate and from the membrane layer (7).

3. Process according to at least either of the preceding claims, **characterized in that** the modifications (4) are introduced into the glass substrate along multiple annularly closed peripheral contours (5), wherein the peripheral contours (5) enclose one another.

4. Process according to at least one of the preceding claims, **characterized in that** adjacent peripheral contours (5) are introduced into the glass substrate at parallel spacings from one another.

5. Process according to at least one of the preceding claims, **characterized in that** the parameters of the laser radiation along a first peripheral contour (5) deviate from the parameters of the laser radiation along a second peripheral contour (5) enclosed by the first peripheral contour (5).

6. Process according to at least one of the preceding claims, **characterized in that** at least one of the etching attacks is delimited in particular by use of a masking on portions of the peripheral contour (5).

7. Process according to at least one of the preceding claims, **characterized in that** the membrane layer (7) and/or the sacrificial layer (6) are applied by means of a sputtering process.

8. Process according to at least one of the preceding claims, **characterized in that** the peripheral contour (5) is introduced along a cylindrical or polygonal peripheral surface.

9. Process according to at least one of the preceding claims, **characterized in that** the peripheral contour is introduced in a side facing towards the membrane layer (7) in a manner deviating from how a peripheral contour (5) is introduced on a side facing away from the membrane layer (7).

10. Process according to at least one of the preceding claims, **characterized in that** the modifications (4) are introduced into the glass substrate before the sacrificial layer (6) and the membrane layer (7) are applied.

11. Process according to at least one of the preceding claims, **characterized in that** firstly the sacrificial layer (6) is applied over the entire surface area and then the sacrificial layer (6) is removed in the intermediate regions between the peripheral contours (5).

12. Process according to at least one of the preceding claims, **characterized in that** at least one further modification (4) is introduced into the glass substrate within the peripheral contour (5).

13. Process according to at least one of the preceding claims, **characterized in that** the glass substrate is made to oscillate at a high frequency, in particular by means of ultrasound, during the etching attack.

## Revendications

1. Procédé de fabrication de microstructures dans un substrat en verre, notamment en verre de quartz, avec des surfaces (2) en forme de membrane, en pont ou en surplomb, suite à un affaiblissement de matière provoqué par un procédé de gravure, par un enlèvement de matière pour créer au moins un évidement (3) dans le substrat en verre, avec les étapes de procédé suivantes :
- l'introduction de modifications (4) au moyen d'un rayonnement laser le long d'au moins un contour périphérique (5) de préférence fermé de manière annulaire dans le substrat en verre et
- la gravure du substrat en verre à partir d'un côté du substrat en verre détourné de la couche de membrane (7), moyennant quoi l'enlèvement de matière s'effectue au moins essentiellement le long du contour périphérique (5) des modifications (4) des zones modifiées par laser,
- **caractérisé par**
- l'application d'une couche sacrificielle (6) sur le substrat en verre dans une première zone qui englobe le contour périphérique (5) des modifications (4),
- l'application d'une couche de membrane (7) sur la couche sacrificielle (6) dans une deuxième zone englobant la première zone,
- la gravure du substrat en verre à partir d'un côté du substrat en verre détourné de la couche de membrane (7) jusqu'à ce que la couche sacrificielle (6) soit atteinte, de telle sorte qu'il se produise une dissolution ou une réduction de la couche sacrificielle (6) et finalement une séparation de la liaison du contour du substrat en verre englobé par le contour périphérique (5) du substrat en verre environnant ainsi que de la couche de membrane (7).

2. Procédé selon au moins l'une quelconque des revendications précédentes, **caractérisé en ce qu'**après l'introduction des modifications (4) dans le substrat en verre au moyen d'un rayonnement laser, on soumet d'abord au moins une surface extérieure du substrat en verre à une attaque de gravure et on introduit ainsi au moins un évidement (3), et **en ce qu'**ensuite, successivement, la couche sacrificielle (6) dans la première zone et la couche de membrane (7) dans la deuxième zone sont appliquées au moins sur la surface extérieure pourvue de l'évidement (3), et ensuite la surface extérieure du substrat en verre détournée de la couche de membrane est soumise à une nouvelle attaque de gravure jusqu'à ce que la liaison du contour du substrat en verre englobé par le contour périphérique (5) soit séparée du substrat en verre environnant ainsi que de la couche de membrane (7).

3. Procédé selon au moins l'une quelconque des revendications précédentes, **caractérisé en ce que** les modifications (4) sont introduites dans le substrat en verre le long de plusieurs contours périphériques fermés de manière annulaire (5), les contours périphériques (5) s'englobant les uns les autres.

4. Procédé selon au moins l'une quelconque des revendications précédentes, **caractérisé en ce que** des contours périphériques (5) adjacents sont introduits dans le substrat en verre en étant espacés parallèlement les uns des autres.

5. Procédé selon au moins l'une quelconque des revendications précédentes, **caractérisé en ce que** les paramètres du rayonnement laser le long d'un premier contour périphérique (5) diffèrent des paramètres du rayonnement laser le long d'un deuxième contour périphérique (5) englobé par le premier contour périphérique (5).

6. Procédé selon au moins l'une quelconque des revendications précédentes, **caractérisé en ce qu'**au moins l'une des attaques de gravure est limitée à des zones partielles du contour périphérique (5), notamment par l'utilisation d'un masquage.

7. Procédé selon au moins l'une quelconque des revendications précédentes, **caractérisé en ce que** la couche de membrane (7) et/ou la couche sacrificielle (6) sont appliquées au moyen d'un procédé de pulvérisation.

8. Procédé selon au moins l'une quelconque des revendications précédentes, **caractérisé en ce que** le contour périphérique (5) est introduit le long d'une surface périphérique cylindrique ou polygonale.

9. Procédé selon au moins l'une quelconque des revendications précédentes, **caractérisé en ce que** le contour périphérique est introduit dans un côté tourné vers la couche de membrane (7) différent d'un contour périphérique (5) sur un côté détourné de la couche de membrane (7).

10. Procédé selon au moins l'une quelconque des revendications précédentes, **caractérisé en ce que** les modifications (4) sont introduites dans le substrat en verre avant l'application de la couche sacrificielle (6) et de la couche de membrane (7).

11. Procédé selon au moins l'une quelconque des revendications précédentes, **caractérisé en ce que** l'on procède d'abord à une application de la couche sacrificielle (6) sur toute la surface, puis à une ablation de la couche sacrificielle (6) dans les zones intermédiaires entre les contours périphériques (5).

12. Procédé selon au moins l'une quelconque des revendications précédentes, **caractérisé en ce qu'**au moins une autre modification (4) est introduite dans le substrat en verre à l'intérieur du contour périphérique (5) .

13. Procédé selon au moins l'une quelconque des revendications précédentes, **caractérisé en ce que,** pendant l'attaque de gravure, le substrat en verre est soumis à des vibrations à haute fréquence, notamment au moyen d'ultrasons.
